(19) Europäisches Patentamt
European Patent Office
Office européen des brevets

(11) **EP 2 283 511 B1**

(12) **EUROPEAN PATENT SPECIFICATION**

(45) Date of publication and mention
of the grant of the patent:
**23.10.2013  Bulletin 2013/43**

(51) Int Cl.:
***H01J 37/32*** *(2006.01)*

(21) Application number: **09742137.4**

(22) Date of filing: **07.05.2009**

(86) International application number:
**PCT/EP2009/055565**

(87) International publication number:
**WO 2009/135919 (12.11.2009 Gazette 2009/46)**

(54) **A SYSTEM FOR ANALYSING PLASMA**

SYSTEM ZUM ANALYSIEREN VON PLASMA

SYSTÈME D'ANALYSE DE PLASMA

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **07.05.2008  GB 0808249**

(43) Date of publication of application:
**16.02.2011  Bulletin 2011/07**

(73) Proprietor: **Dublin City University**
**Dublin 9 (IE)**

(72) Inventors:
• **McNALLY, Patrick**
**Co. Dublin (IE)**
• **LAW, Victor, John**
**Co. Westmeath (IE)**
• **DANIELS, Stephen**
**Dublin D9 (IE)**

(74) Representative: **Moore, Barry et al**
**Hanna Moore & Curley**
**13 Lower Lad Lane**
**Dublin 2 (IE)**

(56) References cited:
**EP-A- 1 189 491        EP-A- 1 205 962**
**JP-A- 2004 071 812        JP-A- 2007 299 652**
**US-A1- 2005 241 761        US-B1- 6 367 329**
**US-E1- R E38 273**

• **LAW ET AL: "Process-induced oscillator frequency pulling and phase noise within plasma systems" VACUUM, PERGAMON PRESS, GB, vol. 82, no. 6, 11 October 2007 (2007-10-11), pages 630-638, XP022457930 ISSN: 0042-207X**
• **LAW V J ET AL: "Passive radio spectroscopy of an atmospheric plasma" ELECTRONICS LETTERS, IEE STEVENAGE, GB, vol. 42, no. 12, 8 June 2006 (2006-06-08), pages 687-688, XP006026810 ISSN: 0013-5194**

## Description

### Field of the Invention

The present invention relates to a system for analysing plasma. The present invention more particularly relates to a system including a sensor for providing an analog signal representative of a characteristic of plasma and an analog-to-digital converter for converting the analog signal into a digital signal for facilitating digital processing thereof.

### Background

Plasma generators for generating plasma are well known in the art. Typically, plasma generators comprise a plasma discharge chamber filled with a working gas such as helium, argon or a mixture of gases. Electrodes are located within the discharge chamber to which a power supply applies a voltage to affect a plasma discharge. Plasma is used for various applications, for example, for waste gas abatement, liquid treatment, surface coating and modification, and biomedical applications such as functional/structural thin films; plasma sterilisation/inactivation. Depending on the application it is desirable that the plasma has certain characteristics. For example, it is known in the art that parallel-plate atmospheric pressure plasma driven at a frequency below ~ 20 kHz operates in a self-organised filamentary or primary glow mode. In contrast, atmospheric pressure plasma driven a frequencies above ~ 20 kHz operates in a secondary glow mode. The transition between these modes may be controlled as is commonly known in the art.

Various types of instrumentation are used to analyse plasma to establish its characteristics. Depending on the instrumentation used, the analytical technique may be based on optical spectroscopy, ion mass spectroscopy or electrical. Analysing plasmas using optical or ion mass spectroscopy is expensive and is typically limited to providing line of sight information. Furthermore, locating and configuring optical or ion mass spectroscopy instrumentation in small geometry plasma generators is difficult and requires an extremely skilled operator.

Electrical monitoring of plasma in the low frequency range (50 Hz to a few 100 KHz) to very high frequency range to ultra high Frequency range (13.56 MHz to 2.56 GHz) using instrumentation known heretofore is also expensive. Oscilloscopes and spectrum analysers which would be typically considered instruments for such analysis have limited band width. For example, at least two oscilloscopes (or spectrum analyzers) are typically required to span the frequency range from DC-pulsed to 2.45 GHz unless complex aliasing or down conversion frequency circuitry is used.

There is therefore a need for a system for analyzing plasma which is relatively inexpensive and non-invasive.

""Process- induced oscillator frequency pulling and phase noise within plasma systems" by V.J. Law, Vacuum 82 (2008) 630- 638, discloses a system for analysing plasma using passive radio spectroscopy.

These and other features will be better understood with reference to the followings Figures which are provided to assist in an understanding of the teaching of the invention.

### Summary

These and other problems are addressed by providing a system for analysing plasma according to claim 1.

Accordingly, a first embodiment of the invention provides a system as detailed in claim 1. Advantageous embodiments are provided in the dependent claims.

These and other features will be better understood with reference to the followings Figures which are provided to assist in an understanding of the teaching of the invention.

### Brief Description Of The Drawings

The present invention will now be described with reference to the accompanying drawings in which:

Figure 1 is a perspective view of a system for analysing plasma.

Figure 2 is a block diagram a detail of the system of Figure 1.

Figure 3 is a perspective view of a detail of the system of Figure 1.

Figure 4 is a schematic circuit diagram of a detail of the system of Figure 1.

Figure 5 is a perspective view of another system for analysing plasma.

Figure 6 is a perspective view of another system for analysing plasma.

Figure 7a is a perspective view of another system for analysing plasma.

Figure 7b is a circuit block diagram of a detail of the system of Figure 7a.

Figure 7c is a block diagram of a component of the circuit of Figure 7b.

Figure 8 is a perspective view of another system for analysing plasma.

Figure 9 is a perspective view of another system in accordance with the teaching of the present invention.

Figure 10 is a detail of the system of Figure 9.

## Detailed Description Of The Drawings

Some exemplary systems will be described to assist in an understanding of the teaching of the disclosure.

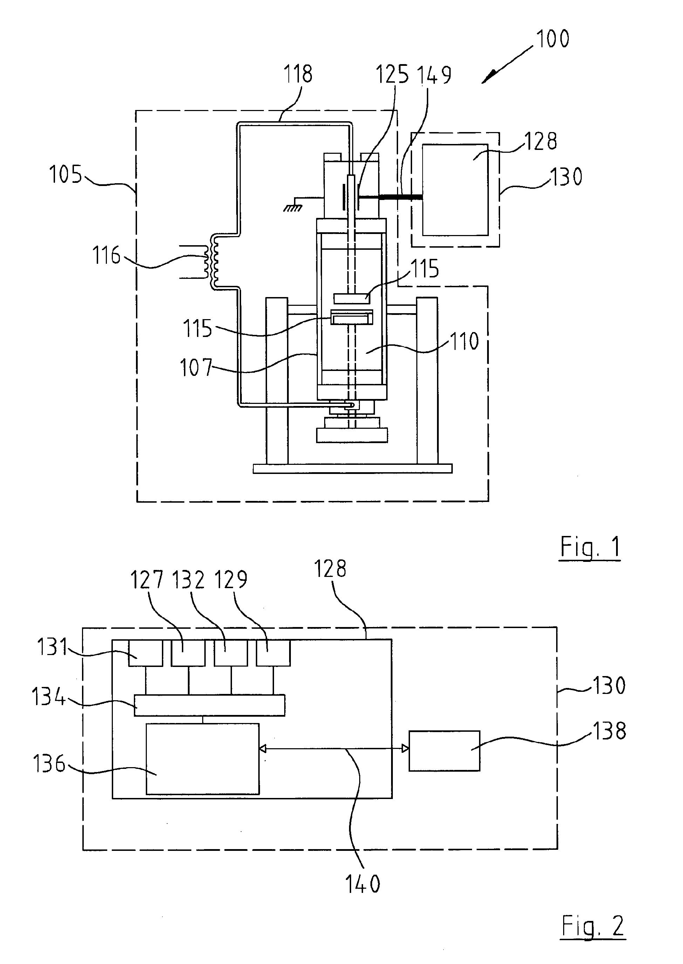

Referring to the drawings and initially to Figure 1 there is provided a system 100 for analysing plasma. The plasma is generated by a plasma generator 105, which may be implemented in accordance with known methodologies. Such known plasma generators 105 typically comprise a housing 107 defining a plasma discharge chamber 110 which may be filled with a working gas. A pair of electrodes 115 are located in the chamber 110 and are coupled to a power supply 116. The power supply 116 operably applies a voltage to effect a plasma discharge in the chamber 110. The power supply 116 is electrically coupled to the electrodes 115 via a power line 118. The electrodes 115 can be arranged in various configurations, for example, parallel-plate, coaxial, and reel to reel. The working gas may be any suitable type of gas such as helium, argon or a mixture of gases such as oxygen, nitrogen, and a liquid precursor such as polydimethylsiloxane. The drive frequency of the power source may be direct current (DC) power supply or it can be an alternating current AC power supply. Typically frequencies used in plasma generators vary from 50 Hz to 2.456 GHz.

The present inventors have realised that the mechanical, electrical and chemical components of the plasma generator 105 results in an electrical noise and an electro-acoustic emission noise signal on the power line 118 between the power supply 116 and the electrodes 115 which is related to the characteristic of the plasma. Specifically, this electrical noise signal on the power line 118 is a summation of the drive frequency of the power supply 116 and the non-linear plasma discharge current-to-voltage (IV) characteristic of the generated plasma in the chamber 110. As the discharge mode changes within the plasma, the generated electrical noise signal on the power line 118 also changes. The electrical noise signal on the power line 118 can therefore be used to analyse the condition of the plasma discharge process in the chamber 110.

To provide for such analysis, the system 100 comprises a sensor which may for example be based on capacitive sensing and include a capacitive means, such as a capacitive clamp 125 for sensing electrical noise on the power line 118. The capacitive clamp provides as an output an analog signal indicative of the sensed characteristic. This analog signal is coupled via an analog to digital convertor to a processing means such as that provided in a computer where a comparable digital signal may be analysed. To provide for such coupling, a preferred implementation provides for the capacitive clamp 125 to be electrically coupled to a sound card 128 installed on a computing means, typically, a laptop computer 130. It will be understood that the term sound card is intended to include any audio card or interface to a computer such as those provided as a computer expansion card to facilitate the input and output of audio signals to/from a computer under control of one or more computer programs. The sound card 128 may be operably coupled to the laptop computer 130 through a SPDIF (Sony/Phillips Digital Interface) or other suitable interface depending on the specific arrangement of sound card used. Alternatively the sound card, may be incorporated into the mother board of the laptop 130.

As shown in Figure 2, an exemplary sound card 128 that may be usefully employed within the context of the present invention typically comprises four ports, namely, a microphone socket 129, a headphone port 127, a MIDI port 131. A volume actuator 132 is provided on the soundcard 128 for controlling the volume of an output signal to headphone socket 127. The capacitive clamp 125 is coupled to the MIDI port 131 for delivering the electrical noise signal to the sound card 128. An audio mixer 134 is provided on the sound card 128 for mixing the analog signal received from the capacitive clamp 125 with other signals allocated to the sound card 128. The audio mixer 134 mixes the analog signal with an audio signal for facilitating audio analysis thereof. An analog-to-digital converter 136 is also provided on the sound card 128 for converting the analog noise signal received from the capacitive clamp 125 via the audio mixer 134 into a digital signal consisting of binary code with a time stamp. A bus 140 interconnects the analog-to-digital converter 136 with a processor 138 of the computer 130 such that the processor 138 receives the digital signal outputted from the analog-to-digital converter 136. As the digital signal is in binary format and includes a time stamp it is suitable for digital processing which is carried out by the processor 138. The software module (firmware) installed on the computer 130 instructs the processor 138 of the laptop 130 to manipulate the digital signal in a predetermined manner.

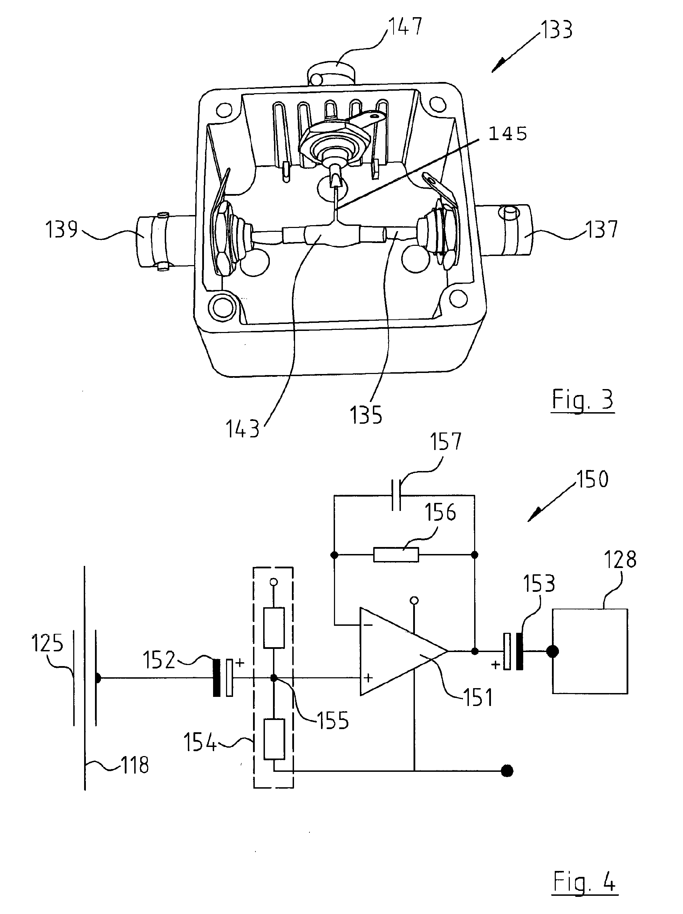

The capacitive clamp 125 operates like a parallel plate capacitor which is charged by the electrical noise on the power line 118. The analog-to-digital converter 136 on the sound card 128 reads the analog voltage signal generated by the capacitive clamp 125 and converts the electrical noise signal into a comparable digital signal. In an exemplary arrangement shown in Figure 3, the capacitive clamp 125 is integrated with a junction box 133. The junction box 133 comprises a power line 135 extending between a first BNC connector 137 and a second BNC connector 139. The first and second BNC connectors 137, 139 are used to releasably couple the respective opposite ends of the power line 135 to the power line 118 of the plasma generator 105 between the chamber 110 and the power supply 116. The capacitive clamp 125 may be provided in the form of a copper clad cable 143 which surrounds or encapsulates the power line 135 intermediate the first and second BNC connectors 137, 139. An output line 145 is electrically coupled at one end to the copper clad cable 143 and terminates at the opposite end in a third BNC connector 147. The third BNC connector 147 is releasably coupled to a cable 149 interconnecting the sound card 128 and the capacitive clamp 125 together. In this way, the sound card 128 is able to receive the electrical noise signal on the power line 118 as captured as a voltage signal by the copper clad cable 143. While a preferred arrangement for a capacitive clamp has been described it will be understood that the capacitive clamp 125 can be provided in numerous alternative arrangements, for example, as a copper foil wrapped around the power line 118. Indeed any sensor that can be used to sense the electrical noise provided on the power line could be usefully employed.

Typically audio sound cards have an input impedance of 1 kΩ to 2 kΩ. As such it will be understood that when sound cards are used as a spectrum analyzer, the input impedance influences the measured circuit and short-circuits low frequency input signals. As a consequence commercial oscilloscope probes, which are designed to operate at impedances of about 1 MΩ cannot be directly used. To enable usage of such probes, the present disclosure provides for use of a buffer 150, such as that shown in Figure 4, that may be operably coupled between the third BNC connector 147 and the sound card 128 so that the output signal from the capacitive clamp 125 is buffered prior to reaching the sound card 128. The buffer 150 isolates the input impedance of the soundcard 128 from the output impedance of the capacitive clamp 125.

The buffer 150 may be provided by a unity gain amplifier 151 which includes inverting and non-inverting inputs and an output. In such an arrangement, an input capacitor 152 is coupled between the capacitive clamp 125 and the non-inverting input of the amplifier 151. An output capacitor 153 is coupled between the output of the amplifier 151 and the sound card 128. A resistor divider 154 coupled between a Vdc power supply and ground is connected to a intermediary node 155 common to the input capacitor 152 and the non-inverting input of the amplifier 151. A feedback path comprising a feedback resistor 156 in parallel with a feedback capacitor 157 is provided between the inverting input and the output of the amplifier 151. The input and output capacitors 152, 153 provide DC isolation up the rated values of the capacitors.

To enable an analysis of the digitised representation of the sensed capacitive signal it is desirable that the computing device incorporates some analysis software. In an exemplary arrangement, the software module installed on the computer 130 may include atmospheric pressure plasma spectrogram software which has been programmed in the National Instruments LabVIEW 8.2 graphical programming language. The programme is designed around the Lab-VIEW Express sound acquire.vi and the Order Analysis Toolkit (OAT) Spectral Map (water fall).vi. The program may be used to provide the captured information in the frequency domain. The program transforms the signal from the capacitive clamp 125 from the time domain to the frequency domain. Viewing the electrical noise and acoustic noise in the frequency domain allows specific frequency bands to be allocated a registration tag that corresponds to a specific part of the circuit. The specific part being mechanical, electrical or plasma related. The amplitude verses frequency data is visually displayed as a function of process time using the OAT waterfall plot.vi and displayed on the colourmap.vi. A High pass filter (1-2 KHz) is used to remove very low frequency environmental noise that swamps the plasma signal. A peak search programme is used to numerically display all peaks within a given frequency span and above a given threshold value. The OAT spectral map.vi collects the spectral data by defining a block of data into a specified number of frames. Each frame equals a set number of FFT points to create a spectrum waveform. These frames (waveforms) are manipulated into a colormap display. The data is saved to a LabVIEW measurement (.lvm) file as a block or as a Microsoft Excel file. The block contains the header information and the number of specified frames in columns.

In operation, the capacitive clamp 125 is connected to the power line 118 by the first and second BNC connectors 137, 139 so that the power line 135 of the junction box 133 is in series with the power line 118 of the plasma generator 105. The sound card 128 is coupled to the capacitive clamp 125 via the third BNC connector 147. The power supply 116 applies a voltage across the electrodes 115 such that a discharge current flows between the electrodes 115 to effect plasma discharge in the chamber 110. The mechanical, electrical and chemical components of the plasma generator 105 results in an electrical noise signal on the power line 118 between the power supply 116 and the electrodes 115. The capacitive clamp 125 is charged by the electrical noise on the power line 118, and the resulting voltage signal is fed to the analog-to-digital converter 136 on the sound card 128. The analog-to-digital converter 136 reads the analog voltage signal from the capacitive clamp 125 and converts it into a digital signal which is fed to the processor 138 of the computer 130 via the bus 140. The software module installed on the laptop computer 130 analyses the digital signal. The digital signal which is representative of electrical noise signal on the power line 118 is suitable for digital processing and is used to analyse the condition of the plasma discharge process in the chamber 110.

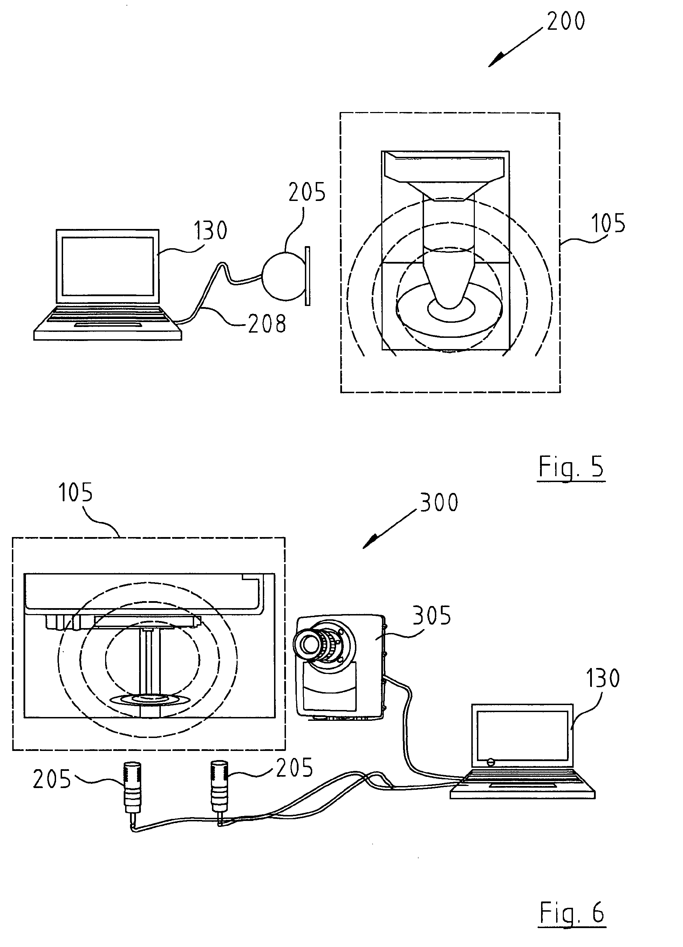

Referring now to Figure 5 there is illustrated another system 200. The system 200 is substantially similar to the system 100, and like components are indicated by the same reference numerals. In this arrangement, instead of providing the sensor as a capacitive clamp 125 as described heretofore, the sensor is provided as a microphone 205 for capturing an acoustic characteristic (sound energy) associated with the plasma generated by the plasma generator 105. The present inventors have realised that plasma in the pressure range of between 200 Torr and 760 Torr supports acoustic and electro-acoustic pressure waves and that these energy pressure waves may be detected by use of a microphone. The microphone 205 is coupled to the microphone socket 129 of the sound card 128 by a cable 208. The analog-to-digital converter 136 receives the analog audio signal from the microphone 205 and converts it into a digital signal including binary code and a time stamp which is suitable for digital processing. The digital signal outputted from the analog-to-digital converter 136 is representative of sound energy associated with the plasma. It will be appreciated by those skilled in the art that the microphone 205 provides a non-invasive and cost effective method for monitoring plasmas that are driven at high voltage levels (1 to $\pm$ 15 kV). Monitoring a plasma driven by such high voltages would be dangerous for an operator using the capacitive clamp 125 as there is a risk of the operator being electrocuted, however as the microphone is a passive device that does not require direct coupling to the plasma generator it can be safely used for such scenarios. The microphone 205 may be omnidirectional or directional. Typically, plasma generators are located in noisy environments and a directional microphone may be used to de-select unwanted environmental noise resulting from electrical fans, motors, etc.

In operation, the microphone 205 is placed in the proximity of the plasma generator 105 outside the chamber 110. The microphone 205 picks up electrical and electro-acoustic energy generated by the plasma and generates an electrical signal representative of the detected energy which is then fed to the analog-to-digital converter 136 on the sound card 128. The software module installed on the computer 130 is programmed to analyse the digital signal outputted by the analog-to-digital converter 136. It will be appreciated by those skilled in the art that two or more microphones 205 may be used to capture the acoustics associated with the plasma. Where provided as two microphones, one of the microphones 205 may be a mono-microphone and the other a stereo-microphone, or both microphones may be stereo.

Referring now to Figure 6 there is illustrated another system 300. The system 300 is substantially similar to the system 100, and like components are indicated by the same reference numerals. Instead of providing the sensor as a capacitive clamp 125, two sensors are provided. The first sensor is provided as a microphone 205 such as described in the system 200 with reference to Figure 5, and the second sensor is provided as an image capture device for capturing an image associated with the generated plasma. A suitable image capture device is for example a digital camera 305. The digital camera 305 is coupled to the computer 130 via a USB port, serial, port or LAN port. The processor 138-described previously with reference to Figure 2- operates as a cross referencing means which cross references the digital images from the digital camera 305 with the electro-acoustic data obtained from the microphone 205. By combining the output of the camera and the sound card it is possible to generate an audio-visual display of both images and audio data. It will be appreciated by those skilled in the art that a video camera with a live feed may be used instead of the digital camera 305.

In operation, the digital camera 305 is placed proximal to the plasma generator 105 but outside the chamber 110. The digital camera 305 captures an image of the plasma in the chamber 110 through the transparent walls of the chamber 110 which is fed to the sound card 128. The camera 305 may also be placed in the proximity of an expanding plasma plume that is eminating out of the plasma chamber 110. A software module installed on the digital camera 305 may be accessed by the processor 138 to provide machine vision data such as object recognition (micro discharge, streams and arcs). The computer 130 may be suitably programmed to analyse the digital image received from the camera 305 and display the digital image on the visual display unit of the computer 305 beside the processed audio data.

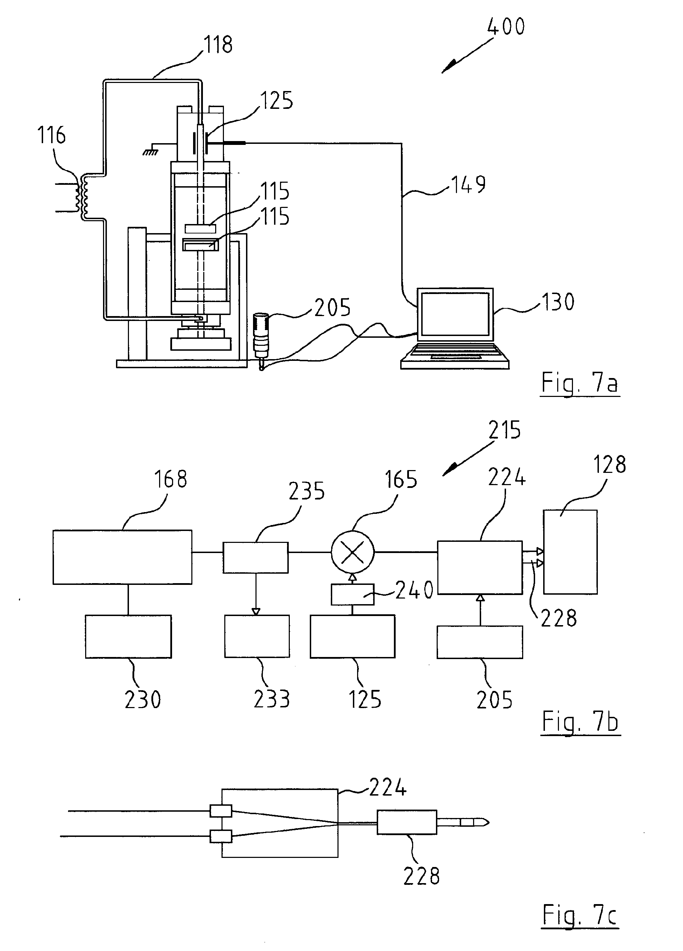

Referring now to Figures 7a, 7b and 7c, there is illustrated another system 400 which comprises two sensors. The first sensor is provided by the capacitive clamp 125 as described in the system 100. The second sensor is provided by the microphone 205 as described in the system 200. The microphone 205 picks up sound energy originating from the plasma. Atmospheric pressure plasma (APP) devices are powered by power supplies using a number of drive frequency bands. These drive frequency bands are typically, in the ranges of 16 kHz to 24 kHz, 10kHz to 100 kHz and the Industrial Scientific and Medical (ISM) frequency of 13.56 MHz. The maximum pass-band of most commercial sound cards is 48 kHz. The first drive frequency band of 16 kHz to 24 kHz may be sampled within the soundcard frequency pass-band. However, the second frequency band of 10kHz to 100 kHz band breaches compact disk (CD) specification. The ISM frequency of 13.56 MHz is also outside the maximum pass-band of soundcards. To sample these out of band drive frequencies a radio frequency mixing circuit 215 may be used to generate an intermediate frequency signal (IF) within the soundcard pass-band by mixing the frequency signal received from the capacitive clamp 125 with a sampling signal (fs). Sound cards designed for DVDs have a pass-band which may accommodate the second frequency band.

The mixing circuit 215 comprises a radio frequency mixer 165 which mixes the drive signal (fd) received from the capacitive clamp 125 with a sampling frequency (fs). A voltage control oscillator (VCO) 168 operates as a local oscillator (LO) for providing the sampling frequency (fs). The sampling frequency (fs) is set by a dc voltage supply 230.

The radio frequency mixer 165 mixes the sampling signal (fs) with the drive signal (fd) and generates an intermediate signal (IF) which is within the pass band frequency of the sound card 128. The sampling frequency (fs) is provided by a voltage controlled oscillator (VCO) 168. For example, when the drive frequency (fd) from the capacitive clamp 125 is 13.562 MHz, the mixer 165 mixes the drive signal with a sampling frequency (fs) of 13.56 $\pm$ 100 kHz such that the intermediate signal (IF) fed to the sound card 128 is approximately 20 kHz. The intermediate signal (IF) of approximately 20 kHz is within the pass band frequency of the sound card 128 and is fed into one of the stereo channels of the soundcard 128. The intermediate signal (IF) is passed to a splice circuit 224 which merges the Mono intermediate signal (IF) signal received from the radio frequency mixer 165 with a Mono audio signal received from the microphone 205. A stereo jack 228 which is plugged into the microphone socket on the sound card 128 receives the two signals from the splice circuit 224. A monitor 233 may be coupled by a coupler 235 intermediate the VCO 168 and the radio frequency mixer 165 for visually monitoring the signal from the VCO 168. To provide the correct voltage level for each stage of the down conversion, an amplifier is placed at the radio frequency mixer 165 input and attenuation pads 240 are placed on the mixer RF and IF ports. The software module installed on the computer 130 is programmed to cross reference the electrical noise captured by the capacitive clamp 125 with the audio sound energy captured by the microphone 205. Thus, the software module operates as a cross referencing means. Cross referencing audio sound energy with plasma electrical noise floor, drive oscillator phase noise (at the fundamental or harmonic) with plasma-surface interactions provides a powerful process diagnostics.

The use of the radio frequency mixer 165 is a cost effective method of acquiring out of band frequency information. When the drive frequency is between 50 kHz and 2.45 GHz, the radio frequency mixer 165 is used to capture harmonic related and non-harmonic electrical noise. A software utility such as that provided by the program LabVIEW (version 8.2 or greater) may be used to process and display the down conversion data together with the audio data but on separate frequency traces.

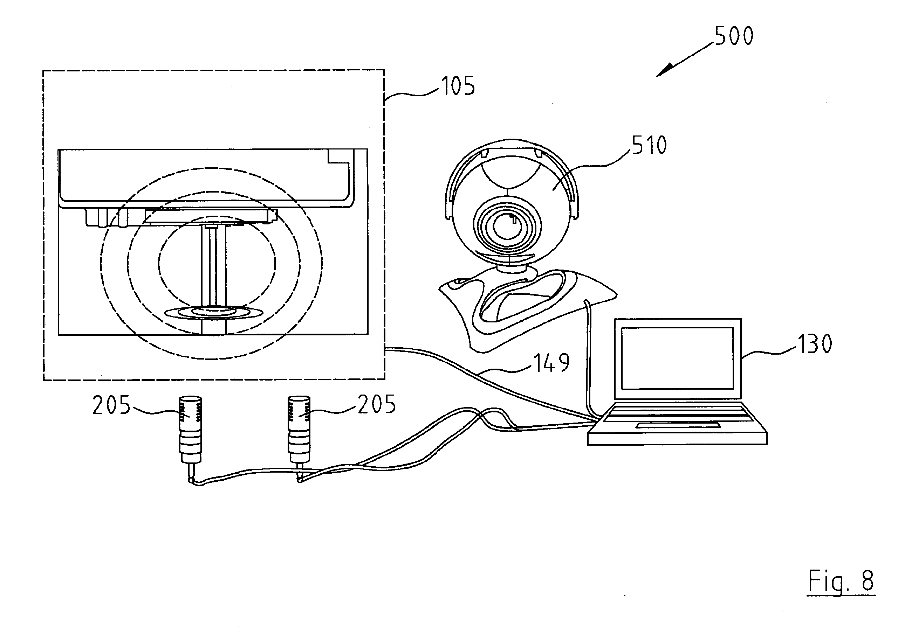

Referring now to Figure 8 there is illustrated another system 500. The system 500 is a combination of the systems 100, 200, 300. Like components are indicated by similar reference numerals. Instead of providing a single sensor as described in each of the systems 100, 200, and 300, the system 500 comprises three sensors. The first sensor is provided by the capacitive clamp 125 as described in the system 100. The second sensor is provided by the microphone 205 as described in the system 200. The third sensor is provided by a low cost USB camera 510 with VGA resolution that has no onboard processing software. The digital camera is connected to the computer 305 using a USB port.

In operation, the digital camera 510 is placed in the proximity of the plasma generator 105 outside the chamber 110. The digital camera 305 captures an image of the plasma in the chamber 110 through the transparent walls of the chamber 110 which is fed to the sound card 128. The camera may also be placed in the proximity of an expanding plasma plume that is emanating out of the plasma chamber 110. The digital image from the camera 510 is displayed on the visual display unit of the computer 130. This arrangement allows visual cross referencing with the electrical and electro-acoustic processed information. The optical image of the plasma provides visually perceptible information on the plasma state.

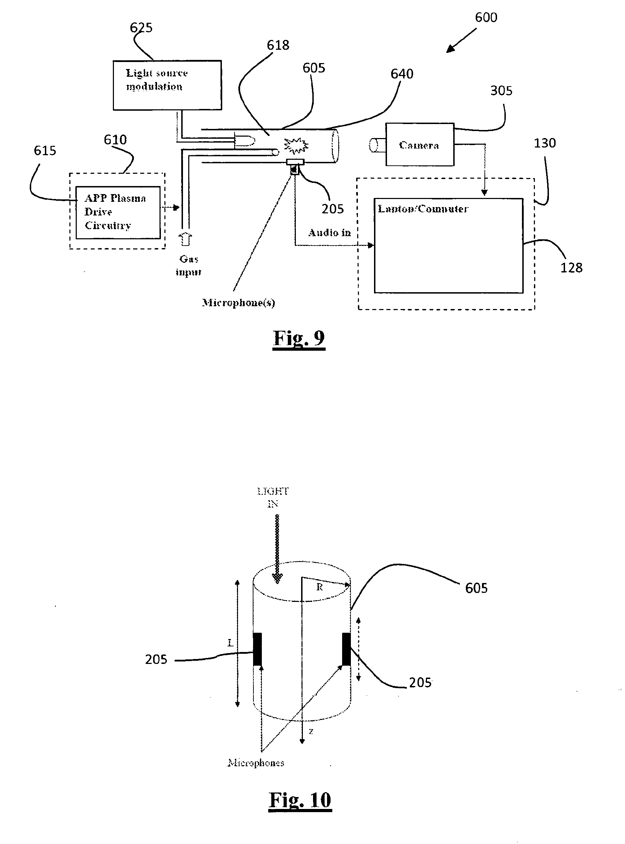

Referring now to Figure 9 there is illustrated another system 600 in accordance with the teaching of the present invention. The system 600 is substantially similar to previously described systems and like components are indicated with similar reference numerals. The main difference is that the system 600 includes a photo-acoustic cell 605 in fluid communication with a plasma source 610 and defines a measuring area 618 for receiving ionised atmospheric gas (plasma) from the plasma source 610. The atmospheric plasma under test is surrounded by the cylindrical (or similar) open-ended cell 605 or chamber whose dimensions are chosen to produce acoustic resonances in the kHz range. In this exemplary arrangement the cell 605 is cylindrical and its resonance frequencies ($f_{jmq}$) can be calculated using the following equation:

## Equation 1

$$f_{jmq} = \frac{c}{2} \cdot \left[ \left( \frac{\alpha_{jm}}{R} \right)^2 + \left( \frac{q}{L} \right)^2 \right]^{1/2}$$

Where:

$f_{jmq}$ is the resonance frequency of the cell,
c is the velocity of light
R is the radius of the cell,
L is the length of the cylinder,
$\alpha_{jm}$ is the $j^{th}$ zero derivative of the $m^{th}$ Bessel function divided by $\pi$,
q is the longitudinal mode index,
m is the azimuthal mode index, and
j is the radial mode index.

In operation of the system, a photo-acoustic signal is generated inside the cell. The cell 605 acts as a cavity resonator and provides for the amplification of the photo-acoustic signal. The dimensions, specifically in this exemplary arrangement the radius and length of the cell 605 facilitates the generation of standing wave patterns and resulting resonance frequencies, which are representative of the characteristics of the plasma within the cell.

The gas is ionised with an electrical drive circuit 615 with appropriate electrode configuration such that plasma is formed prior to entering the cell 605. The cell 605 maybe fabricated from an insulating material (plastic) or a conducting material (metallic). If the cell 605 is fabricated from a conducting material the inner wall 640 of the cell 605 is anodized/insulated in order to prevent plasma arcing to the cell walls. An exciting means, in this case, a light source 625 excites the plasma in the measuring area 618. The excitation light causes a heat release from the atmospheric plasma/gas in the measuring area 618 due to the relaxation of absorbed light energy through molecular collisions. The release of heat in the measuring area 618 results in the generation of acoustic energy and thermal waves. Thus, the cell 605 may be considered to be an acoustic generator.

The generated acoustic energy is recorded with one or more microphone(s) 205 arranged relative to the plasma to detect acoustic energy in the measuring area 618. The microphone 205 is in communication with a sound card 128 installed on a computer 130 which converts the acoustic energy to digital data for facilitating digital processing of the acoustic energy. The recorded acoustic energy is a measure of the energy absorbed which depends on the intensity of the excitation light and also on the characteristics of the plasma in the measuring area 618. The intensity of the excitation light may be determined and as such the system may be used for providing a characterisation of the plasma in the measuring area 618. For example, the characteristics of the plasma in the measuring area 618 may be determined from the acoustic energy generated in the measuring area 618 using the following equation.

## Equation 2

$$f = \frac{1}{2\pi\sqrt{LC}}$$

Where:

f is the change in frequency of the power source of the drive circuit,
L is the inductance of the measuring area, and
C is the capacitance of the measuring area.

As the frequency of the generated acoustic energy in the can be measured, the only unknown is the equation 2 is LC. However, L is made up of a cell component Lc and a plasma component Lp. Similarly, C is made up of a cell component Cc and a plasma component Cp. Thus, equation 2 may rewritten as shown in equation 3:

## Equation 3

$$f = \frac{1}{(Lc + Lp)(Cc + Cp)}$$

As Lc and Cc are product of the cell 605 and drive circuit 615 f is the change in frequency of the power source caused by the plasma inductance (Lp) and the plasma capacitance (Cp) in the measuring area 618. Lc and Cc may be changed by adjusting the experiment set up. For example, the length, colour, diameter and the material of the cell 605 may be varied. It will therefore be appreciated by recording f for different experimental setups and subtracting these readings the contribution of plasma may be obtained.

The light source 625 may provide a modulated or pulsed light beam to the measuring area 618. The light source 625 may be a light emitting diode (LED) or laser or any other suitable means. The modulated light beam may be modulated using for example a sine or a square wave of varying duty cycles, or of some other modulation type. The light source could also be frequency modulated and of any wavelength, or indeed a continuum spectrum. The excitation light may also be polarized. In general the aim is to match the wavelength of excitation light source to the absorption frequency of the plasma and the duration to the life time of the plasma. The light beam emitted by the light source 625 is usually narrow so as to avoid reflections from the sidewalls of the cell 605. In many situations, the excitation light beam may be coaxial with the longitudinal axis of the cell or parallel to the longitudinal axis of the cell. Alternatively, the excitation beam may be at angle relative to the longitudinal axis of the cell. An image capture device, in this case, a webcam 305 may be provided to record graphical images of the plasma in the measuring area 618. These images may be provided to the computer 130 via a USB port, serial, port or LAN port. The processor 138- described previously with reference to Figure 2- operates as a cross referencing means which cross references the digital images from the webcam 305 with the audio data obtained from the microphone 205. By combining the output of the camera 305 and the sound card 128 it is possible to generate an audio-visual representation of both images and audio data extracted from the measuring area 618. The capacitive clamp- also described previously with reference to Figure 2 is coupled to plasma drive circuit 615 for delivering an electrical noise signal representative of plasma in the measuring area 618 to the sound card 128. The analog-to-digital converter 136 on the sound card 128 reads the analog voltage signal generated by the capacitive clamp 125 and converts the electrical noise signal into a comparable digital signal. The processor 138 is also operable to cross reference the digital signal derived from the electrical noise with both the digital images from the webcam 305 and the acoustic data obtained from the microphone(s) 205. By using feeds from three sensors (microphone, camera, and capacitive clamp) enables the simultaneous measurement of three characteristics of the plasma in the measuring area 618.

It will be appreciated that any desired number of microphones may be used to record the generated acoustic energy and may be located in the measuring area or externally thereof. As illustrated in Figure 10 two microphones 205 are provided in the measuring area 618 of the cell 605. While in Figure 9 a single microphone 205 is provided and located on the wall of the cell. It will be appreciated by those skilled in the art that the positions and quantity of microphones 605 can be varied to optimise the photo-acoustic output to the sound card 128.

It will be understood that what has been described herein are some exemplary systems for analysing plasma. The plasma may be atmospheric plasma or liquid plasma. While the present invention has been described with reference to some exemplary arrangements it will be understood that it is not intended to limit the teaching of the present invention to such arrangements. In this way it will be understood that the invention defined by the appended claims.

Similarly the words comprises/comprising when used in the specification are used to specify the presence of stated features, integers, steps or components but do not preclude the presence or addition of one or more additional features, integers, steps, components or groups thereof.

## Claims

1. A system (600) for analysing plasma, the system comprising:

   at least one sensor (205) being co-operable with a plasma source (610) for providing an analog signal representative of a characteristic of plasma from the plasma source,
   a sound card (128) with an analog-to-digital converter (136) in communication with the sensor arranged to convert the analog signal into a digital signal for facilitating digital processing thereof, and **characterised by** further comprising
   a photo-acoustic cell (605) arranged to define a measuring area (618) within which characteristics of the plasma may be measured.

2. A system as claimed in claim 1, wherein the sound card comprises at least one port for facilitating coupling the at least one sensor to the sound card, and/or the system further comprises an audio mixer operable between the sensor and the analog-to-digital converter for mixing the analog signal with at least one audio signal for facilitating audio analysis thereof, and/or the system further comprises a buffer operable for receiving the analog signal from the sensor and outputting a buffered signal to the analog-to-digital converter.

3. A system as claimed in claim 1 or 2, wherein the sensor is:

(a) operable for capturing an electrical characteristic associated with plasma, or
(b) operable for capturing electrical noise on a power line of an electrical drive circuit used to generate the plasma, or
(c) comprises a capacitive means, or
(d) comprises a capacitive clamp, or
(e) comprises a microphone for capturing sound energy generated by the plasma, or
(f) operable for providing an acoustic characteristic associated with the plasma.

4. A system as claimed in claim 3 when dependent on options (b), (c) or (d), wherein the system further comprises:

   (a) a radio frequency mixer for mixing the analog signal with a sampling signal, or
   (b) a radio frequency mixer for mixing the analog signal with a sampling signal that has a frequency of about 13.56 MHz.

5. A system as claimed in any preceding claim, wherein the system comprises a first sensor operable for capturing an electrical characteristic associated with the plasma, and a second sensor operable for providing an acoustic characteristic associated with the generated plasma.

6. A system as claimed in any preceding claim, wherein the system further comprises an image capturing device for capturing an image of the plasma.

7. A system as claimed in any of claims 1 to 4, wherein the plasma source comprises:

   a discharge chamber, and
   at least one electrode disposed within the discharge chamber.

8. A system as claimed in claim 7, wherein the sensor is located externally of the discharge chamber.

9. A system as claimed in claim 7 or 8, wherein the sensor is located spaced apart from the discharge chamber.

10. A system as claimed in any preceding claim, wherein the digital processing includes transforming the sensed signal from the time domain to the frequency domain.

11. A system as claimed in claim 1, wherein the photo-acoustic cell:

    (a) is tubular, or
    (b) is of circular cross section, or
    (d) defines a passageway for accommodating the flow of ionised gas therethrough, or
    (e) is dimensioned to operate as a resonator cavity.

12. A system as claimed in claim 1 or claim 11, further comprising a light source for operably exciting plasma in the measuring area to generate a photo-acoustic signal, and wherein the sensor is operable for providing an:

    (a) optical representation of the photo-acoustic signal, or
    (b) electrical representation of the photo-acoustic signal.

13. A system as claimed in claim 12, further comprising:

    (a) a first sensor being operable for recording acoustic energy emanating from the photo-acoustic signal, a second sensor being operable for providing an optical representation of the photo-acoustic signal, and a third sensor being operable for providing an electrical representation of the photo-acoustic signal, or
    (b) a first sensor being operable for recording acoustic energy emanating from the photo-acoustic signal, a second sensor being operable for providing an optical representation of the photo-acoustic signal, and a third sensor being operable for providing an electrical representation of the photo-acoustic signal, and wherein each of the three sensors are configured to be simultaneously operable.

**Patentansprüche**

1. System (600) zur Plasmaanalyse, welches System aufweist:

   mindestens einen Sensor (205), der mit einer Plasmaquelle (610) zusammenwirkt, um ein analoges Signal zu schaffen, das für eine Charakteristik eines Plasmas der Plasmaquelle repräsentativ ist, eine Soundkarte (128) mit einem Analog-zu-Digitalwandler (136) in Kommunikation mit dem Sensor und angeordnet, um das analoge Signal in ein digitales Signal zu wandeln, um dessen digitale Verarbeitung zu ermöglichen, und **gekennzeichnet dadurch, dass** es ferner eine fotoakustische Zelle (605) aufweist, die angeordnet ist, um einen Messbereich (618) zu definieren, innerhalb dem Eigenschaften des Plasmas gemessen werden können.

2. System nach Anspruch 1, wobei die Soundkarte mindestens einen Anschluss zum Ermöglichen einer Ankopplung des mindestens einen Sensors an die Soundkarte aufweist, und/oder das System ferner einen Audio-Mixer aufweist, der zwischen dem Sensor und dem Analog-zu-Digitalwandler betreibbar ist, um das analoge Signal mit mindestens einem Audiosignal zu mischen, um dessen Audioanalyse zu ermöglichen, und/oder das System ferner einen Puffer aufweist, der betreibbar ist, um das analoge Signal von dem Sensor zu erhalten und ein gepuffertes Signal an den Analog-zu-Digitalwandler auszugeben.

3. System nach Anspruch 1 oder 2, wobei für den Sensor gilt:

   (a) betreibbar zum Erhalt einer elektrischen Charakteristik assoziiert mit dem Plasma, oder
   (b) betreibbar zum Erhalt eines elektrischen Rauschens auf einer Netzleitung eines elektrischen Antriebskreises, der zur Erzeugung des Plasmas verwendet wird, oder
   (c) aufweisend eine kapazitive Einrichtung, oder
   (d) aufweisend eine kapazitive Klemme oder,
   (e) aufweisend ein Mikrofon zum Erhalt einer Schallenergie, erzeugt durch das Plasma oder,
   (f) betreibbar zum Vorsehen einer mit dem Plasma assoziierten akustischen Charakteristik.

4. System nach Anspruch 3, wenn in Abhängigkeit der Optionen (b), (c) oder (d), wobei das System ferner aufweist:

   (a) einen Radiofrequenzmischer zum Mischen des Analogsignals mit einem Sample-Signal, oder
   (b) einen Radiofrequenzmischer zum Mischen des Analogsignals mit einem Sample-Signal, das eine Frequenz von circa 13,56 MHz hat.

5. System nach einem der vorangehenden Ansprüche, wobei das System einen ersten Sensor aufweist, der zum Erhalt einer zum Plasma gehörenden elektrischen Charakteristik betreibbar ist, sowie einen zweiten Sensor, der zum Vorsehen einer zum erzeugten Plasma gehörenden akustischen Charakteristik betreibbar ist.

6. System nach einem der vorangehenden Ansprüche, wobei das System ferner eine Abbildvorrichtung zum Erstellen eines Bildes des Plasmas aufweist.

7. System nach einem der vorangehenden Ansprüche 1 bis 4, wobei die Plasmaquelle aufweist:

   eine Ausgabekammer, und
   mindestens eine Elektrode die innerhalb der Ausgabekammer angeordnet ist.

8. System nach Anspruch 7, wobei der Sensor außerhalb der Ausgabekammer angeordnet ist.

9. System nach Anspruch 7 oder 8, wobei der Sensor in einem Abstand zur Ausgabekammer angeordnet ist.

10. System nach einem der vorangehenden Ansprüche, wobei das digitale Verarbeiten ein Transformieren des gemessenen Signals von dem Zeitbereich in den Frequenzbereich umfasst.

11. System nach Anspruch 1, wobei die fotoakustische Zelle

    (a) rohrförmig ist, oder
    (b) einen kreisförmigen Querschnitt hat, oder

(d) einen Durchgang zum Aufnehmen der Strömung des ionisierten Gases hierhindurch definiert, oder

(e) dimensioniert ist, um als Resonanzhohlraum zu dienen.

12. System nach Anspruch 1 oder Anspruch 11, ferner aufweisend eine Lichtquelle zum funktionalen Erzeugen des Plasmas in dem Messbereich zur Erzeugung eines fotoakustischen Signals, wobei der Sensor betreibbar ist zum Vorsehen einer

(a) optischen Darstellung des fotoakustischen Signals, oder

(b) einer elektrischen Darstellung des fotoakustischen Signals.

13. System nach Anspruch 12, ferner umfassend:

(a) der erste Sensor ist betreibbar zum Aufnehmen einer akustischen Energie, die von dem fotoakustischen Signal stammt, ein zweiter Sensor ist betreibbar zum Vorsehen einer optischen Darstellung des fotoakustischen Signals, und ein dritter Sensor ist betreibbar zum Vorsehen einer elektrischen Darstellung des fotoakustischen Signals, oder

(b) ein erster Sensor ist betreibbar zum Aufnehmen einer akustischen Energie, die aus dem fotoakustischen Signal stammt, ein zweiter Sensor ist betreibbar zum Vorsehen einer optischen Darstellung des fotoakustischen Signals, und ein dritter Sensor ist betreibbar zum Vorsehen einer elektrischen Darstellung des fotoakustischen Signals, und wobei jeder der drei Sensoren konfiguriert ist, um gleichzeitig betreibbar zu sein.

**Revendications**

1. Système (600) pour analyser du plasma, le système comprenant :

au moins un capteur (205) apte à fonctionner conjointement avec une source de plasma (610) pour fournir un signal analogique représentatif d'une caractéristique du plasma provenant de la source de plasma, une carte son (128) avec un convertisseur analogique-numérique (136) en communication avec le capteur agencé pour convertir le signal analogique en un signal numérique pour faciliter le traitement numérique de celui-ci, et **caractérisé en ce qu'**il comprend en outre une cellule photo-acoustique (605) agencée pour définir une zone de mesure (618) à l'intérieur de laquelle des caractéristiques du plasma peuvent être mesurées.

2. Système selon la revendication 1, dans lequel la carte son comprend au moins un port pour faciliter le couplage du au moins un capteur à la carte son, et/ou le système comprend en outre un mélangeur audio apte à fonctionner entre le capteur et le convertisseur analogique-numérique pour mélanger le signal analogique avec au moins un signal audio pour faciliter l'analyse audio de celui-ci, et/ou le système comprend en outre une mémoire tampon apte à fonctionner pour recevoir le signal analogique provenant du capteur et transmettre au convertisseur analogique-numérique un signal mis en mémoire tampon.

3. Système selon la revendication 1 ou 2, dans lequel le capteur est :

(a) apte à fonctionner pour capturer une caractéristique électrique associée au plasma, ou

(b) apte à fonctionner pour capturer du bruit électrique sur une ligne électrique d'un circuit de commande électrique utilisé pour générer le plasma, ou

(c) comprend des moyens capacitifs, ou

(d) comprend une pince capacitive, ou

(e) comprend un microphone pour capturer de l'énergie sonore générée par le plasma, ou

(f) apte à fonctionner pour fournir une caractéristique acoustique associée au plasma.

4. Système selon la revendication 3 lorsque dépendante des options (b), (c) ou (d), dans lequel le système comprend en outre :

(a) un mélangeur de radiofréquences pour mélanger le signal analogique avec un signal d'échantillonnage, ou

(b) un mélangeur de radiofréquences pour mélanger le signal analogique avec un signal d'échantillonnage qui a une fréquence d'environ 13,56 MHz.

**5.** Système selon l'une quelconque des revendications précédentes, dans lequel le système comprend un premier capteur apte à fonctionner pour capturer une caractéristique électrique associée au plasma, et un second capteur apte à fonctionner pour fournir une caractéristique acoustique associée au plasma généré.

**6.** Système selon l'une quelconque des revendications précédentes, dans lequel le système comprend en outre un dispositif de capture d'image pour capturer une image du plasma.

**7.** Système selon l'une quelconque des revendications 1 à 4, dans lequel la source de plasma comprend :

   une chambre de décharge, et
   au moins une électrode disposée à l'intérieur de la chambre de décharge.

**8.** Système selon la revendication 7, dans lequel le capteur est situé extérieurement à la chambre de décharge.

**9.** Système selon la revendication 7 ou 8, dans lequel le capteur est situé espacé de la chambre de décharge.

**10.** Système selon l'une quelconque des revendications précédentes, dans lequel le traitement numérique inclut la transformation du signal détecté du domaine temporel au domaine fréquentiel.

**11.** Système selon la revendication 1, dans lequel la cellule photo- acoustique :

   (a) est tubulaire, ou
   (b) est de section transversale circulaire, ou
   (d) définit un passage pour accueillir l'écoulement de gaz ionisé à travers celui-ci, ou
   (e) est dimensionnée pour fonctionner comme une cavité de résonateur.

**12.** Système selon la revendication 1 ou 11, comprenant en outre une source de lumière pour exciter de manière opérationnelle le plasma dans la zone de mesure pour générer un signal photo-acoustique, et dans lequel le capteur est apte à fonctionner pour fournir une :

   (a) représentation optique du signal photo-acoustique, ou
   (b) représentation électrique du signal photo-acoustique.

**13.** Système selon la revendication 12, comprenant en outre :

   (a) un premier capteur apte à fonctionner pour enregistrer de l'énergie acoustique émanant du signal photo-acoustique, un deuxième capteur apte à fonctionner pour fournir une représentation optique du signal photo-acoustique, et un troisième capteur apte à fonctionner pour fournir une représentation électrique du signal photo-acoustique, ou
   (b) un premier capteur apte à fonctionner pour enregistrer de l'énergie acoustique émanant du signal photo-acoustique, un deuxième capteur apte à fonctionner pour fournir une représentation optique du signal photo-acoustique, et un troisième capteur apte à fonctionner pour fournir une représentation électrique du signal photo-acoustique, et dans lequel chacun des trois capteurs est configuré apte à fonctionner simultanément.

Fig. 1

Fig. 2

Fig. 3

Fig. 4

200

205

130

208

105

<u>Fig. 5</u>

105

300

305

130

205

205

<u>Fig. 6</u>

Fig. 7a

Fig. 7b

Fig. 7c

Fig. 8

**Fig. 9**

**Fig. 10**

**EP 2 283 511 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **V.J. LAW.** Process-induced oscillator frequency pulling and phase noise within plasma systems. *Vacuum,* 2008, vol. 82, 630-638